# EUROPEAN PATENT APPLICATION

(11) **EP 4 460 164 A1**
(43) Date of publication of application: **06.11.2024**
(21) Application number: 22916541.0
(22) Date of filing: 13.12.2022
(51) Int. Cl.: H10K 30/00, H10K 30/80

(54) **SOLAR CELL AND METHOD FOR FORMING SAME**

(30) Priority: 30.12.2021 KR 20210193377
(71) Applicant: Dongjin Semichem Co., Ltd, Incheon 22824 (KR)
(72) Inventor: LEE, Dong Hyun, Hwaseong-si, Gyeonggi-do 18635 (KR); RYU, Kuk Hyeon, Hwaseong-si, Gyeonggi-do 18635 (KR)
(74) Representative: Grünecker Patent- und Rechtsanwälte PartG mbB
(86) International application number: PCT/KR2022/020194
(87) International publication number: WO 2023/128396

(57) **Abstract**

A solar cell and a method of forming the same are provided. The solar cell includes a substrate, and a plurality of unit cells including a first electrode, an active layer, and a second electrode, in which the unit cells are spaced from each other to expose the substrate. Accordingly, using an insulating structure or non-power generation area where the unit cells are spaced from each other and the substrate is exposed, it is possible to minimize leakage current, and to increase power generation efficiency.

## Description

### [Technical Field]

The present invention relates to a solar cell and a method of forming the same, and more specifically, to a solar cell having an insulating structure or a non-power generation area in which unit cells are spaced from each other and a substrate is exposed, and a method of forming the same.

### [Background Art]

A solar cell is a device that directly converts solar energy into electrical energy by applying the photovoltaic effect. Such a solar cell may be divided into an inorganic solar cell and an organic solar cell depending on materials of a thin film.

In the organic/inorganic solar cells, an electrode structure that collects electrons and holes is more important in a module structure in which multiple cells are connected than in a single unit cell.

In particular, in the case of various solar cell modules (e.g., OPV, CIGS, PSC, etc.) that adopt a monolithic process, each cell to form the module is formed by a plurality of scribing (e.g., LASER scribing) processes.

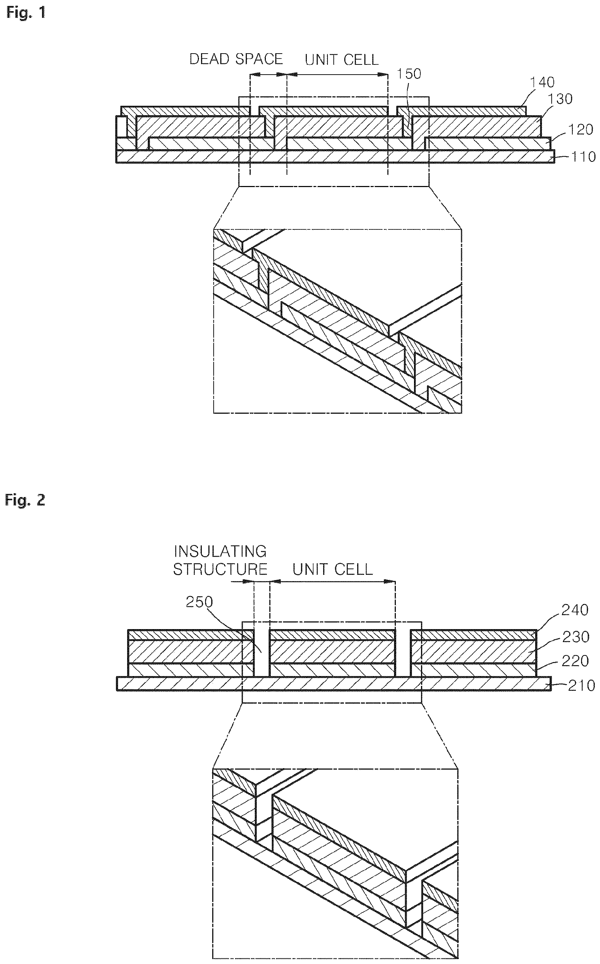

FIG. 1 is a diagram schematically showing a structure of a plurality of cell electrodes of a conventional solar cell.

In the conventional solar cell, as shown in FIG. 1, respective layers that form an electrode layer and an activating layer are connected in a step form.

The conventional structure needs a scribing process for each layer due to the step structure, and a series-connection electrode 150 that connects a lower first electrode 120 and an upper second electrode 140 is disposed between cells.

However, due to the connection electrode disposed between the cells, a problem occurs in that a dead space increases.

The step structure of the conventional solar cell increases leakage current between the cells as well as the increase of the dead space, resulting in a negative impact on device properties.

### [Disclosure]

### [Technical Problem]

Therefore, the present invention has been made in view of the above problems, and it is an object of the present invention to provide a solar cell having an insulating structure or a non-power generation area in which unit cells are spaced from each other and a substrate is exposed, and a method of forming the same.

### [Technical Solution]

In accordance with an aspect of the present invention, the above and other objects can be accomplished by the provision of a solar cell including: a substrate; and a plurality of unit cells that are formed on the substrate and include a first electrode, an active layer, and a second electrode, in which the unit cells are spaced from each other.

The unit cells may be spaced from each other at intervals ranging from 0.1 mm to 2 mm.

At least one of the first electrode or the second electrode may be a transparent electrode.

The solar cell may be provided for low illuminance of 100 to 10,000 lux.

The solar cell may further include a connection electrode that connects the unit cells.

The connection electrode may extend from the second electrode, and may be connected to the first electrode of a neighboring unit cell.

The second electrode and the connection electrode may be made of the same material.

The second electrode and the connection electrode may be formed in an integrated structure.

The first electrode and the second electrode may be each made of one or more of indium tin oxide (ITO), fluorine tin oxide (FTO), antimony tin oxide (ATO), zinc oxide, tin oxide, ZnoGa₂O₃, ZnO-Al₂O₃, platinum, ruthenium, palladium, iridium, rhodium (Rh), osmium (Os), carbon (C), WO₃, TiO₂, Au, Cu, Ag, In, Ru, Pd, Ir, graphene, and conductive polymer.

The connection electrode may be made of one or more of indium tin oxide (ITO), fluorine tin oxide (FTO), antimony tin oxide (ATO), zinc oxide, tin oxide, ZnoGa₂O₃, ZnO-Al₂O₃, platinum, ruthenium, palladium, iridium, rhodium (Rh), osmium (Os), carbon (C), WO₃, TiO₂, Au, Cu, Ag, In, Ru, Pd, Ir, graphene, and conductive polymer.

The active layer may include at least one of an activating layer, an electron transporting layer, or a hole transporting layer.

The activating layer may include a perovskite light absorption layer.

The solar cell may further include a battery disposed in a spaced portion between the unit cells.

In accordance with another aspect of the present invention, there is provided a method of forming a solar cell, including providing a substrate, and forming a plurality of unit cells on the substrate to be spaced from each other so that the substrate is exposed, in which the unit cell includes a first electrode, an active layer, and a second electrode.

The forming the unit cells includes a single scribing process.

The method may further include forming a connection electrode that connects the plurality of unit cells.

The forming the unit cells may include forming the first electrode on the substrate, forming the active layer on the first electrode, and forming the second electrode on the active layer.

### [Advantageous effects]

According to the solar cell and the method of forming the same according to the present invention, it is possible to minimize leakage current by disposing unit cells to be spaced from each other to expose a substrate and providing insulation between unit cells.

Further, it is possible to increase the power generation efficiency of a solar cell device through minimizing an insulating structure or a non-power generation area.

Further, it is possible to achieve process simplification by forming an insulating structure through a single scribing process, thereby reducing process costs.

In addition, it is possible to decreasing power and efficiency losses, especially during low-illuminance power generation.

### [Description of Drawings]

FIG. 1 is a diagram schematically showing a structure of a plurality of cell electrodes of a conventional solar cell.
FIG. 2 is a diagram showing a schematic diagram of a solar cell according to an embodiment of the present invention.
FIG. 3 is a perspective view showing connection electrodes in a solar cell according to an embodiment of the present invention.
FIG. 4 is a diagram showing measurement results in a low-illuminance environment of a solar cell according to an embodiment of the present invention.
FIG. 5 is a diagram showing 1 sun (outdoor) measurement results of the solar cell according to an embodiment of the present invention.
FIG. 6 is a flowchart showing a method of forming a solar cell according to an embodiment of the present invention.
FIG. 7 is a diagram showing a first process in the method of forming unit cells of the solar cell in FIG. 6.
FIG. 8 is a diagram showing a second process in the method of forming the unit cells of the solar cell in FIG. 6.
FIG. 9 is a diagram showing a third process in the method of forming the unit cells of the solar cell in FIG. 6.

### [Best Mode]

Hereinafter, preferred embodiments of the present invention will be described with reference to the accompanying drawings. Embodiments of the present invention may be modified into various other forms, and the scope of the invention is not limited to the embodiments described below. The embodiments of the present invention are provided to more specifically describe the invention to those skilled in the art. Accordingly, shapes and sizes of elements in the drawings may be exaggerated for clear description, and elements represented by the same reference numerals in the drawings are the same elements.

In the present description, a solar cell refers to a module structure in which a plurality of unit cells is connected in a narrow sense, but refers to a device including the module structure and other components such as a battery in a broad sense. In other words, the solar cell according to the embodiments of the present invention may refer to a photovoltaics system, which may include a component that receives light and converts the light into electricity (a solar cell in a narrow sense), and may further include a device such as a battery capable of converting generated electricity into a specific form or storing the generated electricity (a solar cell in a broad sense).

In the present invention, an insulating structure or a non-power generation area refers to a structure or an area where a substrate is exposed between unit cells. Unlike the conventional solar cell in which a connection electrode is disposed between unit cells, the solar cell according to the present invention has an insulating structure in which a substrate is exposed to minimize leakage current and minimize a non-power generation area.

As an example, the solar cell may be a monolithic solar cell. A monolithic device refers to a device in which various devices are integrated and stacked on one substrate.

FIG. 2 is a diagram showing a schematic diagram of a solar cell according to an embodiment of the present invention.

For clarity of description, FIG. 2 mainly shows a module structure of an electrode structure, but may include other components not shown.

Referring to FIG. 2, a solar cell according to the present embodiment includes a substrate 210 and a plurality of unit cells. In the case of a crystalline silicon solar cell, the substrate of the solar cell may be a silicon wafer, and the solar cell is manufactured by forming junctions and electrodes thereon. In the case of a thin film solar cell, the substrate of the solar cell may be a support on which a thin film grows, which may be made of glass, plastics, stainless steel, etc. The substrate is a plate member that maintains a mechanical strength of a photovoltaic generation module. As another example, the substrate 210 may be a semiconductor substrate made of a compound such as GaN.

The substrate 210 is generally transparent to allow incidence of external light, but may be opaque depending on a counter electrode. As an example, the substrate may be made of transparent glass or plastics. Specific examples of plastics include polyethylene terephthalate (PET), polyethylene naphthalate (PEN), polycarbonate (PC), polypropylene (PP), polyimide (PI), tri acetyl cellulose (TAC), or the like.

The substrate of the solar cell according to the present embodiment may be a flexible substrate, instead of a rigid substrate such as a semiconductor wafer or glass. The flexible substrate may include a metal flexible substrate, an ultra-thin glass substrate, a plastic substrate, or the like.

The unit cell may include a first electrode 220, an active layer 230, and a second electrode 240.

The basic unit of the solar cell is a unit cell. Since voltage output from one cell is very small, within about 1 Volt, a power generator manufactured by connecting multiple unit cells in series and parallel and packaging them in one piece to obtain voltage and output within a practical range may be provided.

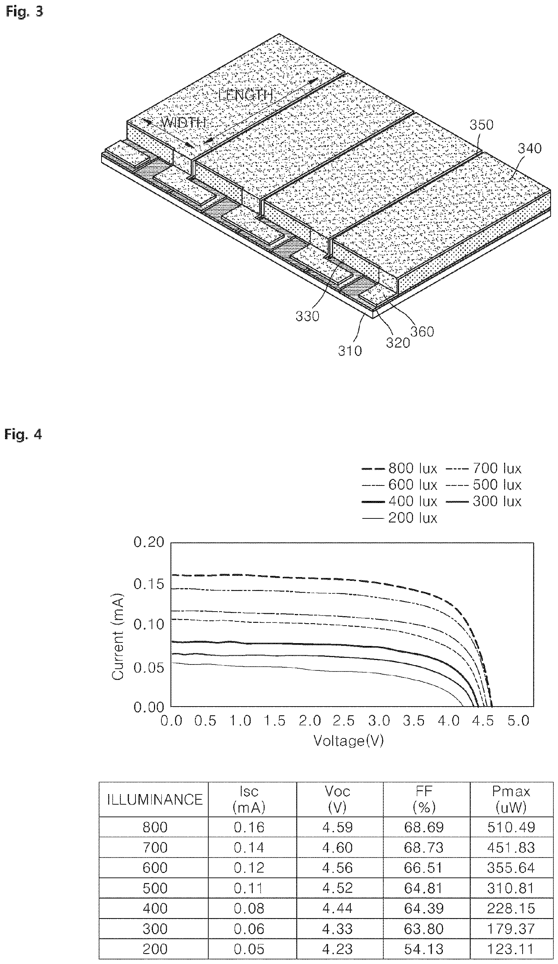

Specifically, an aspect ratio of the unit cell, the ratio of a horizontal width to a vertical length, is 8 or less. Here, the horizontal width (short side in FIG. 3) refers to a side of the unit cell where the connection electrode is formed, and the vertical length (long side in FIG. 3) refers to a side on which scribing is performed in the unit cell. In a case where the aspect ratio is set to 8 or less, there is an advantage that the power generation efficiency of the solar cell increases to the same level or higher than that of the conventional solar cell in the case of 1 sun (outdoor) measurement.

Respective unit cells of the solar cell according to the present invention are disposed to be spaced from each other to expose the substrate. The width of an exposure portion 250 of the substrate between the unit cells may be in the range of 0.1 mm to 2 mm or 0.1 mm to 1 mm. By adjusting the width of the exposure portion 250 to the above range, the power generation area per unit area may be increased, compared to the conventional solar cell.

The insulating structure between the unit cells may be formed by, ideally, a single scribing process (for example, laser or physical scribing).

Here, by arranging the insulating structure on the exposure portion of the substrate between the unit cells, the unit cells may be completely physically shortcircuited, thereby minimizing leakage current.

Here, the width of the insulating structure between the unit cells may be the same.

Alternatively, the widths of the insulating structures between the unit cells are not the same and may differ from each other within an allowable error range.

Here, the insulating structure may be formed to be exposed to the air, or may be covered with an insulating material. In particular, in a case where a vacuum cannot be maintained for a final product, the insulating structure may be covered with the insulating material.

In the conventional solar cell in which connection electrodes are disposed between the unit cells shown in FIG. 1, in the case of a module with a unit cell width of 1 cm, the non-power generation area where the connection electrodes are disposed in manufacturing the module through multi-layer scribing must be secured to be equal to or greater than approximately 1 mm. In contrast, the width of the insulating structure where the substrate is exposed between the unit cells according to the present embodiment is at least 0.1 mm. As a result, the width of the insulating structure or the non-power generation area is reduced to 1/10 compared to the conventional solar cell. As the width of the non-power generation area decreases, the amount of power generation per unit area increases. In the solar cell according to the present embodiment, the insulating structure between the unit cells may have a width of 2 mm or less.

The insulating structure between the unit cells may be formed by performing patterning to form fine gaps between the unit cells. The patterning is performed to partially remove thin films formed on a glass substrate, and is mainly achieved by laser scribing. The scribing method is not limited to the laser scribing, and may also be achieved by other physical scribing methods.

In a case where the patterning is performed using the laser scribing, the width of the insulating structure may be determined by the resolution of a laser beam at the wavelength used.

In a modified embodiment, the solar cell of the present embodiment may have batteries individually disposed in spaced portions.

The advantage of the solar cell-battery integrated device is that the battery can be continuously used under sunlight without a separate charging method.

Specifically, in order to increase the power generation efficiency, the solar cell according to the present embodiment may have a configuration in which the battery is disposed in the insulating structure in which the substrate is exposed between the unit cells. In the case of this battery disposition, the width of the spaced portion may increase.

The active layer 230 of the solar cell according to the present embodiment includes at least one of an activating layer, an electron transporting layer, or a hole transporting layer.

As an example, the active layer 230 may include the activating layer, the electron transporting layer, and the hole transporting layer. As another example, the active layer 230 may include the electron transporting layer and the activating layer. As still another example, the active layer 230 may include the activating layer.

The hole transporting layer is a layer that helps smooth transport of holes between the first electrode and the activating layer.

The hole transporting layer may be made of a single molecule hole transport material (spiro-MeoTAD [2,2',7,7'-tetrakis (N,N-p-dimethoxy-phenylamino)-9,9'-spirobifluorene]) or a polymer hole transport material (P3HT [poly (3-hexylthiophene)].

The electron transporting layer is a layer that helps smooth transport of electrons between the second electrode and the activating layer.

The electron transporting layer may be made of metal oxide semiconductor (TiO₂, SnO₂) or PCBM (phenyl-C61-butyric acid methyl ester).

The activating layer may include a perovskite light absorption layer, and in this case, it is possible to achieve high photoelectric conversion efficiency.

The light absorption layer serves to absorb external light on the surface of metal oxide particles to generate electrons. A material that shows excellent photoelectric conversion efficiency as the light absorption layer may be methyl ammonium lead iodide (CH₃NH₃PbI₃) compound, which is known to absorb light between approximately 400 nm and 800 nm.

A material with a perovskite crystal structure that serves as the light absorption layer is a mixture of inorganic and organic materials and has a molecular formula AMX₃. Representative examples thereof may include the above-mentioned methyl ammonium lead iodide (CH₃NH₃PbI₃, MAPbI₃) or formamidinium lead iodide (CH(NH₂)₂PbI₃, FAPbI₃). In the molecular formula of AMX₃, "A" represents an organic cation, "M" represents a metal cation, and "X" represents a halogen anion. An organic/organic hybrid halide containing the above ingredients shows high photoelectric conversion efficiency when used as the light absorption layer in the solar cell due to its unique crystallization behavior and photoelectric properties.

Organic/inorganic hybrid perovskite materials have excellent photoelectric properties such as a high visible light absorption coefficient, ease of bandgap control, excellent charge mobility, and a long charge diffusion length, and may show high efficiency of 25% or higher when used as light absorption materials for solar cells. The perovskite materials having these excellent properties may effectively absorb visible light of indoor lighting and photoelectrically convert the light, thereby showing excellent efficiency even in low-illuminance environments.

According to the present embodiment, the solar cell may have a thickness less than 10 um. Specifically, the solar cell according to the present embodiment may have a thickness of 500 nm or greater and less than 5 um. In a case where the thickness of the solar cell is too thin, there is no problem when forming electrodes, but the thickness of the light absorption layer may become thin, which may result in decrease in photoelectric efficiency. In the case of PSC, the light absorption layer may have a thickness of 300 nm to 500 nm. Therefore, considering the thickness of the counter electrode and the electron/hole absorption layer, the lower limit of the thickness is preferably about 500 nm or greater.

Compared to the thickness of a conventional dye-sensitized solar cell (DSC) of about 10 to 20 um, the solar cell according to the present embodiment is advantageous in that it can provide a solar cell with a thinner thickness.

FIG. 3 shows a solar cell including connection electrodes according to an embodiment of the present invention.

In a case where solar cells are connected in series, the voltage increases in proportion to the number of cells, and in a case where the solar cells are connected in parallel, the current increases. Using this principle, it is possible to manufacture a module with desired voltage and current.

Referring to the drawings, the solar cell of the present embodiment may further include a connection electrode 360 that connects unit cells. The connection electrode may extend from the second electrode 340 of the unit cell, and may be connected to the first electrode of a neighboring unit cell. The solar cell of the present embodiment may include a contact metal that is patterned and then heat-treated to minimize contact resistance when connecting the connection electrode with the first electrode of the neighboring unit cell.

In this embodiment, the second electrode 340 and the connection electrode may be made of the same material, so that contact resistance is minimized.

Further, the second electrode and the connection electrode may be formed as an integrated structure, and the integrated structure may be formed by depositing the second electrode and the connection electrode at the same time, thereby shortening the process.

The second electrode and the connection electrode may be formed as the integrated structure through a patterning process.

In this embodiment, at least one of the first electrode or the second electrode may be provided as a transparent electrode. That is, at least one of the first electrode or the second electrode must be a transparent electrode.

In a case where both the first and second electrodes are transparent electrodes, it is possible to provide a semi-transparent solar cell, and in a case where only one of the first and second electrodes is a transparent electrode, it is possible to provide a highly efficient solar cell with minimized efficiency loss.

Here, the transparent electrode refers to an electrode formed on the surface of a solar cell on which light is incident and having high light transmittance and high electrical conductivity.

The first electrode 320 and the second electrode 340 are each made of one or more of indium tin oxide (ITO), fluorine tin oxide (FTO), antimony tin oxide (ATO), zinc oxide, tin oxide, ZnoGa₂O₃, ZnO-Al₂O₃, platinum, ruthenium, palladium, iridium, rhodium (Rh), osmium (Os), carbon (C), WO₃, TiO₂, Au, Cu, Ag, In, Ru, Pd, Ir, graphene, and conductive polymer.

The connection electrode is made of one or more of indium tin oxide (ITO), fluorine tin oxide (FTO), antimony tin oxide (ATO), zinc oxide, tin oxide, ZnoGa₂O₃, ZnO-Al₂O₃, platinum, ruthenium, palladium, iridium, rhodium (Rh), osmium (Os), carbon (C), WO₃, TiO₂, Au, Cu, Ag, In, Ru, Pd, Ir, graphene, and conductive polymer.

In this embodiment, the first electrode may be made of fluorine tin oxide (FTO), and the second electrode and the connection electrode may be made of metal, for example, gold (Au). In this case, it is possible to implement a solar cell with superior efficiency.

FIG. 4 shows measurement results of the solar cell of the present embodiment in a low-illuminance environment.

Referring to FIG. 4, in a case where the insulating structure is disposed between the unit cells according to the embodiment of the present invention, the solar cell may show excellent characteristics with an FF (fill factor) of 64% or higher at low illuminance (1,000 lux or less).

Recently, as the demand for indoor Internet of Things (IoT) sensors that can be driven with low power (average 20 to 50 uW) has increased exponentially, the need to develop a wireless power system that can generate and supply power in an indoor low-illuminance environment has emerged.

In general, indoor lighting illuminance of residential and commercial buildings is equal to or lower than 5.0*10⁻² mW/cm² (200 to 1000 lux), which is very lower than the standard light intensity driven by a solar cell (1 Sun, 100 mW/cm²). Accordingly, power loss due to interfacial defects and charge traps, which does not appear under solar cell standard test conditions (STC), may appear as serious problems under low-illuminance light sources, and thus, the solar cell device structure optimized under the solar cell standard test conditions (STC) may not guarantee high efficiency in the indoor low-illuminance environment.

As described above, the solar cell according to the embodiment of the present invention can minimize leakage current by providing insulation between unit cells, which may be a desirable alternative to a low-illuminance solar cell that can generate power in the indoor low-illuminance environment.

In this embodiment, the solar cell is intended for low illuminance of 100 to 10,000 lux. Specifically, in a case where the solar cell is used for low illuminance of 100 to 1,500 lux, and more specifically, for low illuminance of 200 to 800 lux.

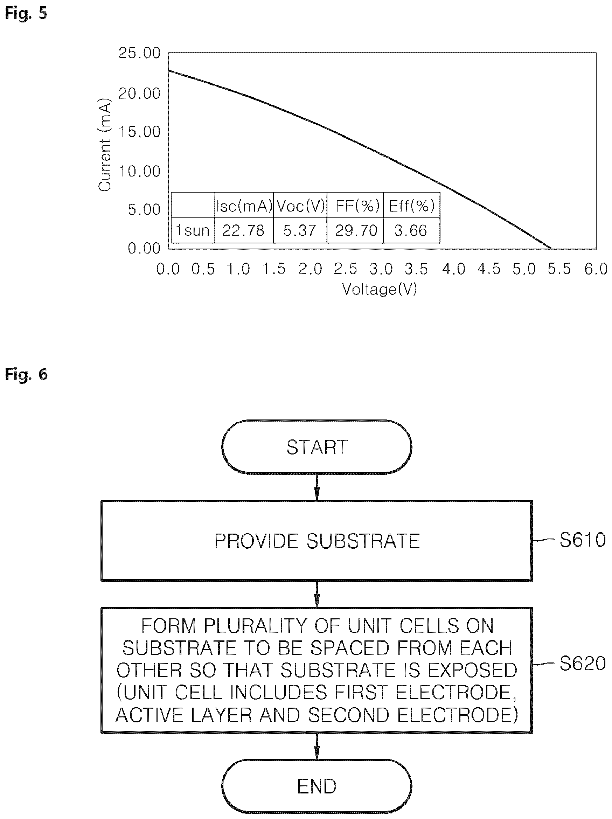

FIG. 5 shows 1 sun (outdoor) measurement results of the solar cell according to an embodiment of the present invention.

According to the solar cell of the present embodiment, it is possible to minimize leakage current by providing insulation between unit cells. Accordingly, it is possible to provide an optimization principle and mechanism of a device structure for solar cell development under a low-illuminance indoor lighting condition.

However, in the solar cell having the insulating structure between the unit cells according to the present embodiment, in a case where the activating layer includes a perovskite light absorption layer of 10 cm² in FIG. 5, the FF is 29% in 1 sun (outdoor) measurement, which shows a bad result.

This is largely influenced by the voltage drop resulting from the sheet resistance of the first and second electrodes. In fact, high density carriers (electrons, holes) generated at high illuminance show a high current value, and result in large power loss in a case where the sheet resistance is the same at Pₗₒₛₛ = I²R. However, since the current value is relatively low in low illuminance, power loss has relatively less impact on the solar cell structure.

Referring to FIGs. 4 and 5, the solar cell having the insulating structure between the unit cells according to the present embodiment is suitable for low-illuminance environments, and may not be suitable for use in 1 sun (outdoor), that is, outdoors.

FIG. 6 is a flowchart showing a method of forming a solar cell according to an embodiment of the present invention.

As described with reference to FIG. 4, the solar cell according to the present embodiment provides the solar cell structure suitable for low-illuminance environments.

In fact, the efficiency loss of the solar cell increases in proportion to the amount of current generated and the moving distance of carriers. According to the present embodiment, it is possible to propose a structure capable of solving the problems of the dead space and leakage current of the conventional solar cell in a low-illuminance environment, and provide a solar cell design capable of minimizing efficiency loss due to voltage drop.

In a method of forming the solar cell according to an embodiment of the present invention, first, a substrate is provided (S610).

Then, a plurality of unit cells is formed on the substrate to be spaced from each other so that the substrate is exposed (S620).

In addition, a connection electrode that connects a plurality of unit cells may be formed. The connection electrode contacts an electrode of a unit cell with the opposite electrode of a neighboring unit cell to connect the unit cells.

The connection electrode according to the present embodiment is not disposed in an insulating structure or a non-power generation area between the unit cells, but extends from the second electrode and is connected to the neighboring unit cell.

The unit cell includes a first electrode, an active layer, and a second electrode. In providing the unit cells, the first electrode is formed on a substrate, the active layer is formed on the first electrode, and the second electrode is formed on the active layer.

In providing the unit cells in step S620, a one-time scribing process may be performed.

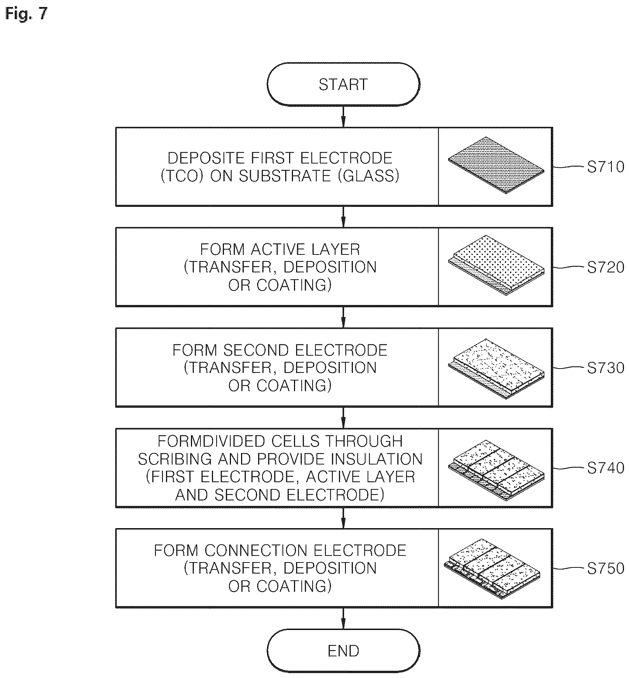

FIG. 7 is a diagram showing in detail a first process of the method of forming the unit cells of the solar cell, according to an embodiment of the present invention.

First, the first electrode is deposited on the substrate (S710). The first electrode may be a transparent electrode.

Then, the active layer is formed on the first electrode (S720). The active layer is formed using a transfer, deposition or coating method.

Then, the second electrode is formed on the active layer (S730).

Subsequently, an insulating structure is formed in which the substrate is exposed between the unit cells through a scribing (laser or physical) process (S740). In step S740, each unit cell includes the first electrode, the active layer, and the second electrode.

Then, a connection electrode is formed (S750).

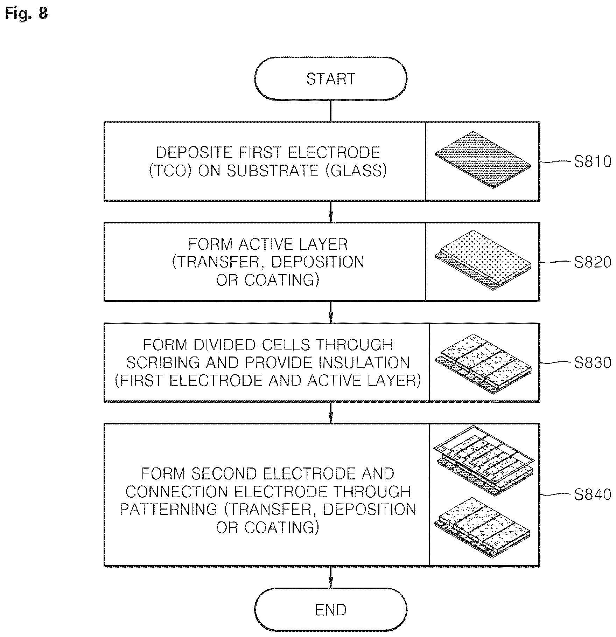

FIG. 8 is a diagram showing in detail a second process of the method of forming the unit cell of the solar cell, according to an embodiment of the present invention.

First, the first electrode is deposited on the substrate (S810) .

Then, the active layer is formed on the first electrode (S820). The active layer is formed using a transfer, deposition or coating method.

Then, an insulating structure is formed in which the substrate is exposed between the unit cells through a scribing (laser or physical) process (S830). In step S830, each unit cell includes the first electrode and the active layer.

Then, the second electrode and the connection electrode are formed on the active layer (S840) . Here, the second electrode is formed through patterning. The connection electrode is also formed through patterning.

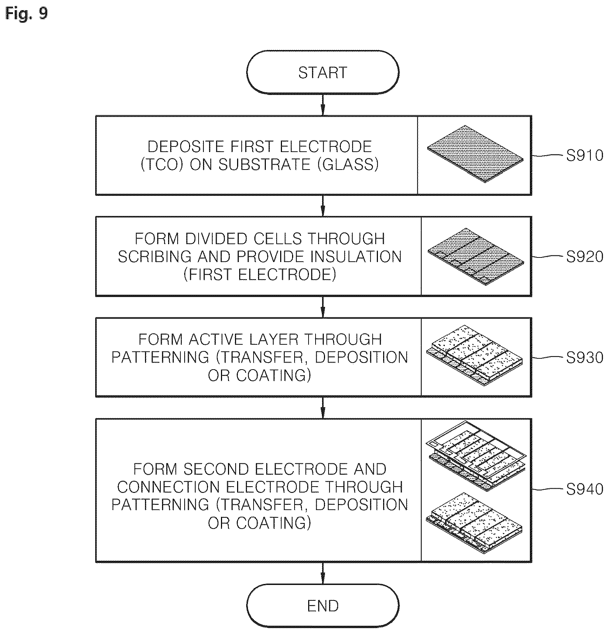

FIG. 9 is a diagram showing in detail a third process of the method of forming the unit cells of the solar cell, according to an embodiment of the present invention.

First, the first electrode is deposited on the substrate (S910).

Then, an insulating structure is formed in which the substrate is exposed between the unit cells through a scribing (laser or physical) process (S920). In step S920, each unit cell includes the first electrode.

Then, the active layer is formed on the first electrode (S930). The active layer is formed through patterning.

Then, the second electrode and the connection electrode are formed on the active layer (S940). Here, the second electrode is formed through patterning. The connection electrode is also formed through patterning.

The terms used in the present description are intended to describe specific embodiments, and are not intended to limit the invention. Unless it is clear from the context, singular expressions should be considered to have a plural meaning. Terms such as "include", "comprise", "have", and the like should not be interpreted to exclude additional elements other than elements described in the specification.

The invention is not limited by the above-described embodiments and the attached drawings, but should be defined by the attached claims. Accordingly, various forms of substitutions, modifications, and changes may be made by those skilled in the art without departing from the technical spirit of the invention as set forth in the claims, and these are also considered to fall within the scope of the invention.

## Claims

1. A solar cell comprising:
a substrate; and
a plurality of unit cells that are formed on the substrate and include a first electrode, an active layer, and a second electrode,
wherein the unit cells are spaced from each other.

2. The solar cell according to claim 1, wherein the unit cells are spaced from each other at intervals ranging from 0.1 mm to 2 mm.

3. The solar cell according to claim 1, wherein at least one of the first electrode or the second electrode is a transparent electrode.

4. The solar cell according to claim 1, wherein the solar cell is provided for low illuminance of 100 lux to 10,000 lux.

5. The solar cell according to claim 1, further comprising: a connection electrode that connects the unit cells.

6. The solar cell according to claim 5, wherein the connection electrode extends from the second electrode, and is connected to the first electrode of a neighboring unit cell.

7. The solar cell according to claim 5, wherein the second electrode and the connection electrode are made of the same material.

8. The solar cell according to claim 6, wherein the second electrode and the connection electrode are formed in an integrated structure.

9. The solar cell according to claim 1, wherein the first electrode and the second electrode are each made of one or more of indium tin oxide (ITO), fluorine tin oxide (FTO), antimony tin oxide (ATO), zinc oxide, tin oxide, ZnoGa₂O₃, ZnO-Al₂O₃, platinum, ruthenium, palladium, iridium, rhodium (Rh), osmium (Os), carbon (C), WO₃, TiO₂, Au, Cu, Ag, In, Ru, Pd, Ir, graphene, and conductive polymer.

10. The solar cell according to claim 5, wherein the connection electrode is made of one or more of indium tin oxide (ITO), fluorine tin oxide (FTO), antimony tin oxide (ATO), zinc oxide, tin oxide, ZnoGa₂O₃, ZnO-Al₂O₃, platinum, ruthenium, palladium, iridium, rhodium (Rh), osmium (Os), carbon (C), WO₃, TiO₂, Au, Cu, Ag, In, Ru, Pd, Ir, graphene, and conductive polymer.

11. The solar cell according to claim 1, wherein the active layer includes at least one of an activating layer, an electron transporting layer, or a hole transporting layer.

12. The solar cell according to claim 11, wherein the activating layer includes a perovskite light absorption layer.

13. The solar cell according to claim 1, further comprising: a battery disposed in a spaced portion between the unit cells.

14. A method of forming a solar cell, comprising:
providing a substrate; and
forming a plurality of unit cells on the substrate to be spaced from each other so that the substrate is exposed,
wherein each unit cell includes a first electrode, an active layer, and a second electrode.

15. The method according to claim 14, wherein the forming the unit cells includes a single scribing process.

16. The method according to claim 14, further comprising:
forming a connection electrode that connects the plurality of unit cells.

17. The method according to claim 14, wherein the forming the unit cells includes:
forming the first electrode on the substrate;
forming the active layer on the first electrode; and
forming the second electrode on the active layer.
